Europäisches Patentamt

European Patent Office

Office européen des brevets

(11) Publication number: **0 349 328**
**A2**

(12) **EUROPEAN PATENT APPLICATION**

(21) Application number: **89306633.2**

(22) Date of filing: **29.06.89**

(51) Int. Cl.⁵: **G 01 R 13/34**
**G 01 R 35/00**

(30) Priority: **30.06.88 US 213806**

(43) Date of publication of application:
**03.01.90 Bulletin 90/01**

(84) Designated Contracting States:
**CH DE FR GB LI NL**

(71) Applicant: **TEKTRONIX, INC.**
**Howard Vollum Park 14150 S.W. Karl Braun Drive P.O. Box 500**
**Beaverton Oregon 97077 (US)**

(72) Inventor: **Chao, Peter S.**
**7300 S.W. 171st Drive**
**Aloha Oregon 97007 (US)**

**Tilden, Mark D.**
**4880 S.W. 192nd**
**Aloha Oregon 97007 (US)**

(74) Representative: **Burke, Steven David et al**
**R.G.C. Jenkins & Co. 26 Caxton Street**
**London SW1H 0RJ (GB)**

(54) **Self-adjusting oscilloscope.**

(57) A digital oscilloscope has a vertical amplifier for adjustably offsetting and amplifying an input signal and a digitizer for digitizing the amplifier output signal after it reaches an adjustable trigger level to provide a data sequence controlling a waveform display on a screen. The oscilloscope includes a computer automatically adjusting trigger level, vertical gain, vertical offset, and digitizing frequency to provide a waveform display representing the amplifier output signal. The computer adjusts the trigger level while monitoring digitizer output to measure minimum and maximum peaks of the amplifier output signal and sets the trigger level between the measured peaks. The computer then iteratively adjusts amplifier gain and offset until it determines that a waveform display controlled by the digitizer output would have minimum and maximum peaks vertically separated by a substantial distance on the oscilloscope screen. The computer estimates the period of the input signal from the digitizer output sequence and adjusts digitizing frequency so that the digitizer output sequence represents a few cycles of the amplifier output signal.

FIG.1

Description

## SELF-ADJUSTING OSCILLOSCOPE

### Background of the Invention

The present invention relates to digital oscilloscopes and in particular to a digital oscilloscope that automatically adjusts its gain, offset, and digitizing frequency to provide a waveform display representing one or more cycles of a periodic input signal.

In a typical digital oscilloscope, a vertical amplifier adjustably amplifies and offsets an input signal to produce an output signal. A trigger comparator compares the amplifier output signal to an adjustable trigger level and generates a trigger signal whenever the amplifier output signal reaches the trigger level. A digitizer digitizes the amplifier output signal with an adjustable digitizing frequency after detecting the trigger signal to produce a digital waveform data sequence representing the time varying magnitude of the amplifier output signal. The waveform data sequence is stored in an acquisition memory and a display controller thereafter reads the waveform data sequence from the acquisition memory and generates a waveform display on a screen representing the data sequence.

Typically an operator manually adjusts oscilloscope operation using controls on the oscilloscope front panel. The operator adjusts the horizontal time scale of a waveform display by changing the digitizing frequency at which an input signal is converted and adjusts the vertical scaling of the waveform display by changing the gain of the vertical amplifier. The operator also adjusts the vertical position of the waveform on the screen by changing the magnitude of an offset signal input to the vertical amplifier. The operator can manually adjust the trigger level.

However, even experienced oscilloscope operators do not always find it easy to properly adjust an oscilliscope to obtain a stable, suitably representative waveform display, particularly when nothing is known beforehand about the characteristics of an input signal. When the input signal is initially amplified and digitized, no waveform may actually appear on the oscilloscope screen, as for example when the vertical offset signal is too positive or too negative. If the trigger level is improperly adjusted, the resulting waveform display may be unsteady. If the digitizing frequency is too high, only a portion of one cycle of the amplifier output signal may be digitized and a periodic input signal may initially appear to be constant. If the digitizing frequency is too low aliasing may cause the waveform data to misrepresent the frequency or amplitude of the input signal.

### Summary of the Invention

In a digital oscilloscope a vertical amplifier produces an output signal by adjustably offsetting and amplifying an input signal. After the amplifier output signal crosses an adjustable trigger level, a digitizer digitizes the amplifier output signal with an adjustable digitizing frequency to produce an output waveform data sequence controlling a waveform display on a screen. In accordance with the invention, a computer within the oscilloscope carries out an "autoset" routine wherein it automatically adjusts trigger level, vertical gain, vertical offset, and digitizing frequency so that the oscilloscope provides a stable waveform display representing a few cycles of the input signal.

In accordance with typical operation of the invention, the computer initially minimizes vertical gain and digitizing frequency and sets offset to 0 volts. Thereafter the computer iteratively adjusts the trigger level while monitoring digitizer output data sequences to determine minimum and maximum peaks of the amplifier output signal. After setting the trigger level midway between the determined minimum and maximum peaks, the computer iteratively adjusts amplifier gain and offset while monitoring digitizer output until it determines that a last produced waveform data sequence has minimum and maximum data elements within a predetermined range and differing by at least a minimum amount. The range and minimum are chosen so that a waveform display controlled by the last produced waveform data sequence will have minimum and maximum peaks appearing on the screen, vertically separated by a substantial distance.

In accordance with another aspect of the invention, the computer estimates the period of the amplifier output signal from the digitizer output and adjusts the digitizing frequency so that the digitizer generates a waveform data sequence during an interval equal to three to five of the estimated periods.

In accordance with a further aspect of the invention, with the digitizing frequency set to the last adjusted value, the computer iteratively readjusts vertical gain and offset while monitoring digitizer output until it again determines that a last produced waveform data sequence has minimum and maximum data elements within the predetermined range and differing by at least the minimum amount. Thereafter, the computer re-estimates the period of the input signal based on the last produced waveform data sequence and again adjusts the digitizing frequency so that the digitizer will thereafter provide an output waveform data sequence representing three to five re-computed periods. Unless the input signal frequency is very high, the vertical gain and offset re-adjustment is performed while using a higher digitizing frequency. Therefore, effects of aliasing on the apparent minimum and maximum magnitude or period of the amplifier output signal suggested by the digitizer output sequence are usually substantially eliminated.

The subject matter of the present invention is particularly pointed out and distinctly claimed in the concluding portion of this specification. However, both the organization and method of operation of the invention, together with further advantages and objects thereof, may best be understood by reference to the following description in connection with the accompanying drawings wherein like reference characters refer to like elements.

## Brief Description of the Drawing

FIG. 1 is a block diagram of relevant portions of a digital oscilloscope; and
FIGS. 2-7 are flow charts illustrating operation of the computer of FIG. 1 in carrying out the present invention.

## Description of the Preferred Embodiment

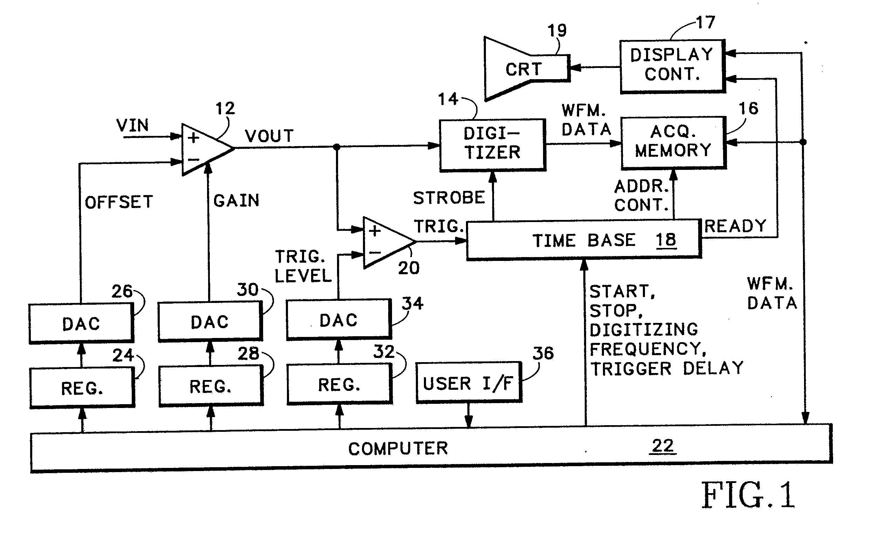

The present invention relates to a digital oscilloscope that automatically adjusts its own operating parameters including trigger level, digitizing frequency, vertical offset and gain to provide a waveform display representing a few cycles of a periodic input signal. FIG. 1 illustrates relevant portions of the digital oscilloscope in block diagram form. An amplifier 12 offsets and amplifies a DC-coupled input signal VIN to produce an output signal VOUT. A digitizer 14 periodically digitizes VOUT to generate a sequence of 1024 digital data elements representing the time varying magnitude of VOUT. The waveform data sequence is stored in an acquisition memory 16 and a display controller 17 subsequently reads the data sequence out of memory 16. The display controller 17 provides an output signal causing a cathode ray tube (CRT) 19 to generate a waveform display on its screen representing the data sequence. The CRT generates the waveform display, for example, by illuminating one pixel in each of 1024 successive columns of pixels on the screen, each successive column corresponding to a separate successive element of the waveform data sequence. The vertical position on the screen of an illuminated pixel in each column represents the magnitude of a corresponding element of the waveform data sequence.

A computer 22 transmits a START signal to a time base circuit 18 to initiate data acquisition. On receipt of the START signal, the time base circuit 18 awaits a TRIGGER signal from a trigger comparator 20. The trigger comparator 20 generates the TRIGGER signal when the amplifier output signal crosses an adjustable trigger level. Such a level crossing is a "triggering event". Following detection of the TRIGGER signal, time base circuit 18 continues to wait for a predetermined trigger delay time and thereafter begins periodically asserting a STROBE signal. Digitizer 14 produces an output data sequence element representing the current magnitude of VOUT whenever time base circuit 18 asserts the STROBE signal. The time base circuit 18 also provides addressing and write control signals to acquisition memory 16 during acquisition of waveform data so that the acquisition memory stores each output data element of digitizer 14 at a separate address. After 1024 data elements are acquired and stored in memory 16, time base circuit 18 stops asserting the STROBE signal and transmits a READY signal to display controller 17. In response to the READY signal, display controller 17 reads the waveform data sequence out of the acquisition memory and updates the waveform display on CRT 19 accordingly. Thereafter, the time base circuit 18 awaits another TRIGGER signal to commence another data acquisition cycle.

Thus after the computer 22 initiates data acquisition with a START command, the digitizer 14 begins producing waveform data sequences representing VOUT, and the display controller 17 continuously updates the waveform display in response to each data sequence. The data acquisition and display process continues until computer 22 transmits a STOP command to the time base circuit. Between stopping and starting data acquisition, computer 22 may read or write access acquisition memory 16 and may transmit graphics or character data to display controller 17 causing the display controller to produce graphic displays or messages on the screen of CRT 19.

Before generating a START command to initiate data acquisition, computer 22 transmits to time base circuit 18 DIGITIZING FREQUENCY data adjusting the digitizing frequency with which time base circuit 18 asserts the STROBE signal. Thus, when the amplifier output signal VOUT is periodic, the DIGITIZING FREQUENCY data controls the number of cycles of VOUT represented by each waveform data sequence. Computer 22 also transmits TRIGGER DELAY data telling the time base circuit 18 how long to delay commencement of data acquisition following detection of the TRIGGER signal. By increasing or decreasing the trigger delay, computer 22 adjusts the horizontal position on the oscilloscope screen of a point on the waveform display corresponding to the triggering event.

Also, before initiating data acquisition, computer 22 adjusts data values stored in a set of registers 24, 28 and 32 thereby adjusting the offset and gain of amplifier 12 and setting the trigger level to be detected by comparator 20. The data stored in register 24 provides input to a digital-to-analog converter (DAC) 26 supplying an OFFSET signal input to amplifier 12. By increasing or decreasing the OFFSET signal, computer 22 can control the vertical position of the waveform display on the screen of CRT 19 produced in response to digitizer output data sequences. The data in register 28 drives a DAC 30 generating a GAIN signal controlling the gain of amplifier 12. By increasing or decreasing the GAIN signal, computer 22 can control the vertical size of the waveform display. A DAC 34, responsive to data in register 32, supplies a TRIGGER LEVEL signal input to comparator 20 controlling the level of VOUT at which comparator 20 asserts the TRIGGER signal. The TRIGGER LEVEL signal is normally adjusted to a level between the minimum and maximum peaks of VOUT to ensure that comparator 20 will detect a triggering event and assert the TRIGGER signal.

Assume, for example, a suitable digitizer 14 has an input range of -1 volt to + 1 volt. When VOUT is +1 volt or larger, a waveform data sequence element generated by digitizer 14 has maximum value. When this element is subsequently forwarded via memory 16 to display controller 17, the uppermost pixel of a pixel column corresponding to the data element will be illuminated. Conversely, when VOUT is-1 volt or less (i.e., more negative), a waveform data sequence element generated by digitizer 14 is of minimum value and the lowest pixel of the corresponding pixel column is illuminated. Thus, when portions of VOUT are greater than +1 volt or less than -1 volt, the resulting waveform display will be "clipped", having flat peaks corresponding to the out of range portions of VOUT.

Computer 22 may adjust gain, offset, trigger level, trigger delay and digitizing frequency in response to commands from a user via user interface 36. User interface 36 suitably comprises push-buttons or control knobs providing control signal inputs to the computer. The computer interprets these signals as commands. Although an operator may manually adjust oscilloscope operating parameters, even an experienced oscilloscope operator does not always find it easy to obtain a suitably representative waveform display, particularly when the operator knows nothing beforehand about the characteristics of an input signal.

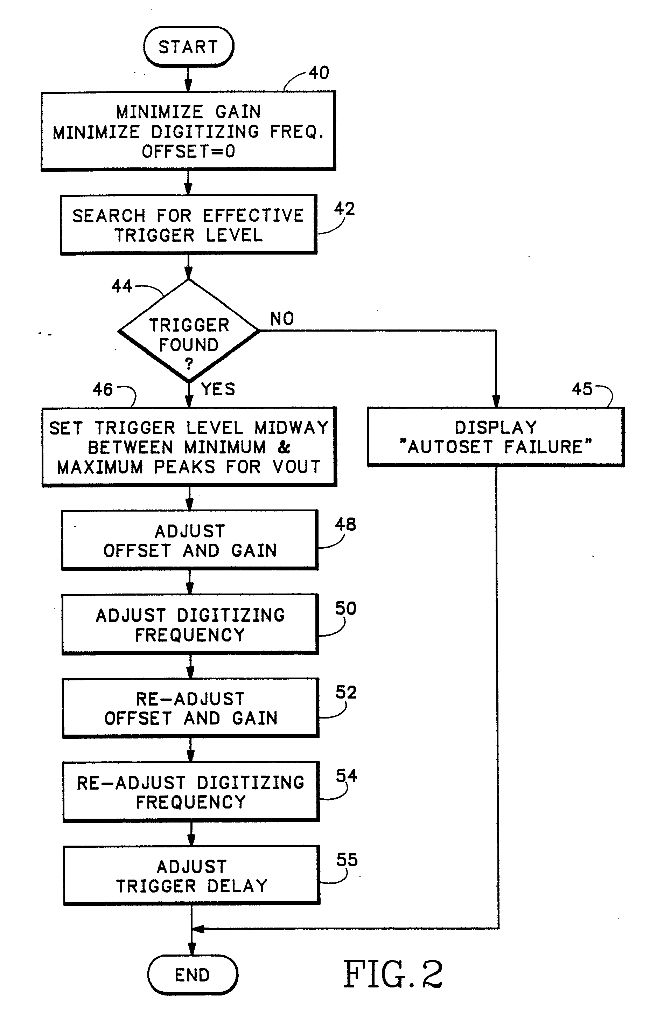

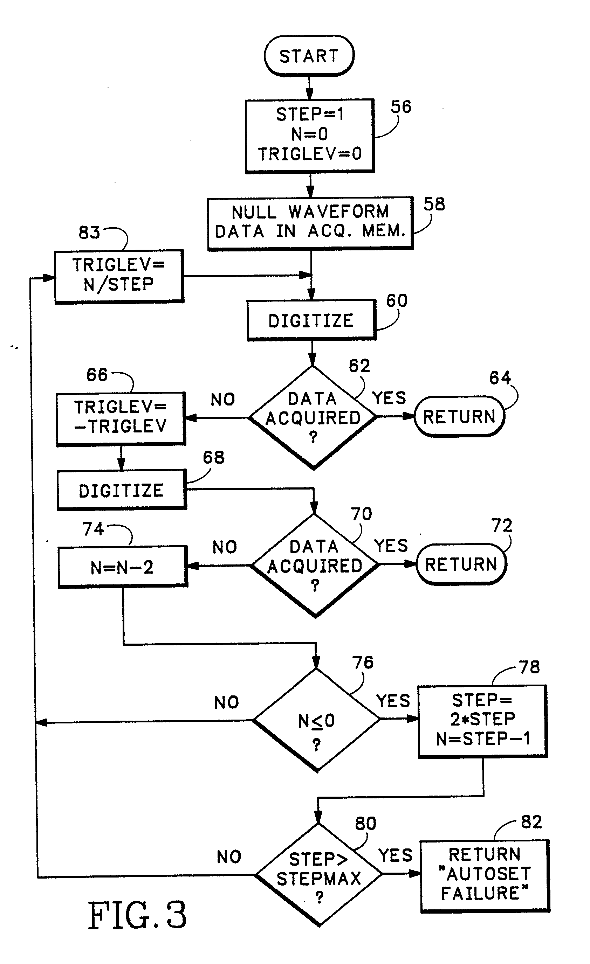

In accordance with the invention, computer 22 responds to an "autoset" command from the user by executing an "autoset" routine whereby it automatically adjusts gain, offset, trigger level, trigger delay and digitizing frequency to obtain a representative waveform display. FIGS. 2-7 are flow charts of the autoset routine carried out by computer 22 of FIG. 1 in response to the autoset command. FIG. 2 illustrates major steps of the autoset routine. FIGS. 3-7 illustrate various steps of the flow chart of FIG. 2 in more detail.

Referring to FIG. 2, computer 22 commences the autoset routine at step 40 wherein it minimizes gain and digitizing frequency and sets offset to 0 volts. Minimizing gain and zeroing offset ensures that unless the input signal has a very large offset or peak-to-peak magnitude, the minimum and maximum peaks of VOUT of FIG. 1 are both within the range, e.g. +1 volt to -1 volt range, of the digitizer. Minimizing digitizing frequency maximizes the likelihood that a digitizer output data sequence represents at least one full cycle of VOUT.

After initializing these operating parameters, the computer iteratively adjusts the trigger level (TRIGLEV) to find an "effective" trigger level, i.e., a trigger level between the minimum and maximum peaks of VOUT that will initiate digitization (step 42). If a trigger level is not found (step 44), the oscilloscope displays the message "AUTOSET FAILURE" on its screen (step 45) and the autoset routine ends.

When a trigger level is found (step 44), the computer next measures minimum and maximum peaks of VOUT (following a procedure described hereinbelow) and adjusts the trigger level to a value midway between the measured peaks (step 46). The computer then iteratively adjusts gain and offset while monitoring the waveform data sequences produced by the digitizer until it determines that minimum and maximum peaks of VOUT are within the +1 to -1 volt range of the digitizer and differ by a predetermined minimum potential (step 48). The minimum potential is selected to ensure that minimum and maximum peaks of a waveform display produced in response to the digitizer output are vertically separated by a substantial distance. The computer estimates the period of VOUT from the last digitizer output data sequence and adjusts digitizing frequency so that the next acquired waveform data sequence will span three to five of the estimated period (step 50).

The offset and gain adjustments performed in step 48 and the digitizing frequency adjustment made in step 50 were based on waveform data acquired using a low digitizing frequency. Due to aliasing effects, the waveform data sequence may misrepresent the amplitude and frequency of the input signal, particularly when the input signal frequency is greater than one half of the initial digitizing frequency. Therefore, after the digitizing frequency is adjusted at step 50 (usually to a much higher value), the computer iteratively re-adjusts offset and gain (step 52) and re-adjusts digitizing frequency (step 54) following procedures similar to those of steps 48 and 50. The re-adjustments performed in steps 52 and 54 reduce the effects of aliasing on apparent amplitude and frequency of VOUT as represented by the digitizer output.

In step 55, the computer 22 of FIG. 1 checks the last produced waveform data sequence to determine the number of data sequence elements that occur before the sequence first rises above the current trigger level setting. Thereafter, the computer adjusts the TRIGGER DELAY data supplied to time base circuit 18 to advance initiation of data acquisition following generation of the TRIGGER signal so that a triggering event occurs at the left end of the waveform display.

Thus, on completion of the autoset routine of FIG. 2, if the input signal is within magnitude, frequency and offset ranges for which the oscilloscope is designed to produce a representative waveform display, such a waveform display will appear with minimum and maximum peaks vertically centered on the oscilloscope screen and with a point representing a triggering event aligned along the left end of the waveform.

FIG. 3 illustrates a subroutine carrying out step 42 of FIG. 2 in more detail. Commencing at step 56, a stored variable STEP is set equal to 1, a stored variable N is set equal to 0, and the trigger level (TRIGLEV) is set to 0 volts. The computer also writes a NULL code into addresses in the acquisition memory (step 58) that are to store waveform data when digitization subsequently commences. The NULL code differs in value from any output sequence element that may be produced by the digitizer. Thereafter, the computer initiates digitization of VOUT (step 60). After a predetermined delay time sufficient for the system to generate and store a waveform data sequence in the acquisition memory, the computer reads the data sequence out of the acquisition memory and checks the magnitude of each sequence element to determine if the digitizer generated data has a value other than the NULL code (step 62). The digitizer generates such data only when data acquisition is triggered, and the trigger comparator triggers data acquisition only when the trigger level is between the minimum and maximum peaks of VOUT.

If the computer determines that data acquisition was triggered, the current trigger level is effective and the subroutine ends, returning to its caller (step 64). If no data was acquired (step 62), the computer sets TRIGLEV to -TRIGLEV (step 66) and restarts data acquisition (step 68). Thereafter, the computer again checks the content of the acquisition memory to see if valid data was acquired (step 70). If so, the subroutine returns (step 72). Otherwise, (step 74) N is decremented by 2. If the incremented value of N is less than or equal to 0 (step 76), the value of STEP is doubled, and N is set equal to STEP-1 (step 78). If STEP is now greater than a maximum value STEPMAX (step 80), the subroutine returns an indication that an effective trigger level was not found (step 82). If in step 76, N is not less than or equal to 0, or if in step 80 STEP is not greater than STEPMAX, TRIGLEV is set equal to N/STEP (step 83) and the subroutine is routed back to step 60. The subroutine continues to loop through steps 60, 62, 66, 68, 70, 74 76, 78, and 80 setting the trigger level to various values until the computer detects data acquisition in one of steps 62 or 70 or until the STEP parameter becomes larger than STEPMAX and the subroutine returns at step 82.

In executing the subroutine of FIG. 3 the computer performs a binary search for an effective trigger level using trigger level voltages adjusted in the following pattern:

$\{+0/1, -0/1, +1/2, -1/2, +3/4, -3/4, +1/4, -1/4, +7/8, -7/8, +5/8, -5/8, +3/8, -3/8, +1/8, -1/8 ... +1/STEPMAX, -1/STEPMAX\}$

Other search patterns may be employed. In the preferred embodiment the value of STEPMAX is chosen to reflect the highest resolution with which the TRIGGER LEVEL signal can be adjusted. For example, if the control data stored in register 32 of FIG. 1 is eight bits, the TRIGGER LEVEL signal can be adjusted with a resolution of 1/256 volts. In such case STEPMAX is chosen to be 256.

When the input signal is very small or nonexistent, the minimum and maximum peaks of VOUT are so close together that the trigger level cannot be adjusted between the minimum and maximum peaks of VOUT. Also, if the offset of the input signal is excessively large, all portions of VOUT may be out of the +1 to -1 volt range example of the TRIGGER LEVEL signal. In either case the subroutine of FIG. 3 will fail to find an effective trigger level and will return via step 82, thereby causing the main autoset routine of FIG. 2 to display the "Autoset Failure" message (step 46) and end. This happens when no input signal is supplied to the oscilloscope or when the input signal is too small to be displayed. However, when the input signal magnitude is within a normal input range for the oscilloscope, the subroutine of FIG. 3 will locate an effective trigger level and will return its value, along with the last value of STEP in step 64 or step 72.

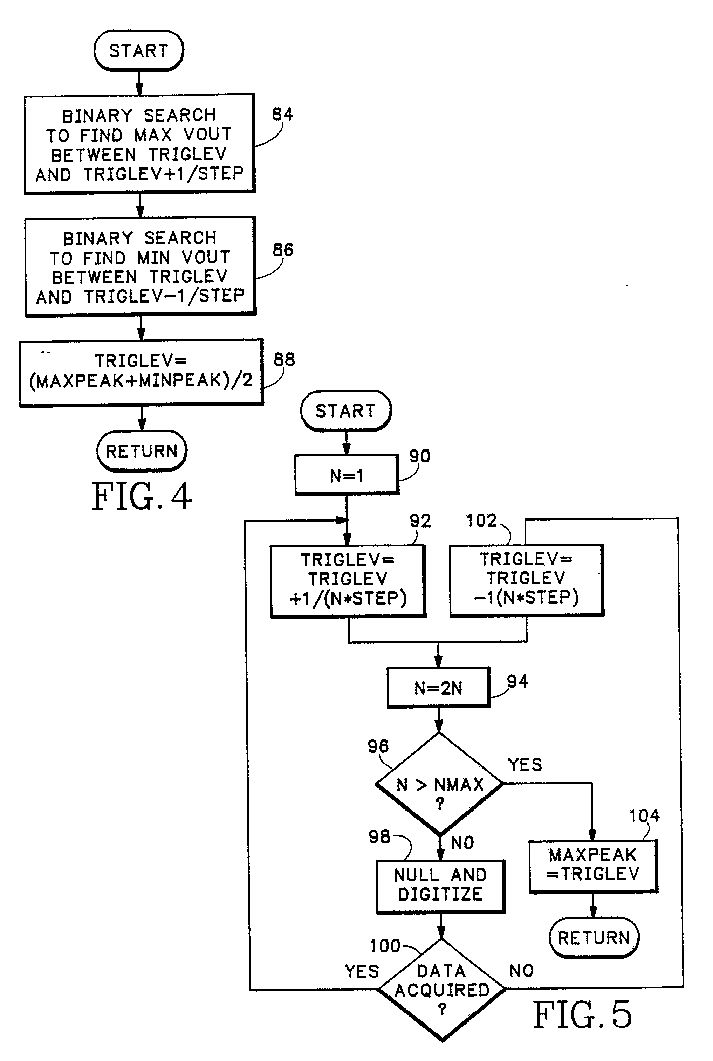

Referring again to FIG. 2, after an effective trigger level is found, the computer determines a trigger level that is midway between minimum and maximum peaks of VOUT (step 46). A subroutine carrying out step 46 is detailed in FIG. 4. Referring to FIG. 4, the computer performs a binary search using trigger levels between TRIGLEV and TRIGLEV+(1/STEP) to find the maximum peak (MAXPEAK) of VOUT (step 84). The computer then performs a similar binary search to locate the minimum peak (MINPEAK) of VOUT between TRIGLEV and TRIGLEV-(1/STEP) (step 86). Thereafter, the subroutine causes the computer to set the trigger level midway between MAXPEAK and MINPEAK (step 88) and then returns to the calling routine.

FIG. 5 is a flow chart illustrating a subroutine carrying out the binary search performed in step 84 of FIG 4 in more detail. Initially, a variable N is set equal to 1 (step 90) and an initial value of TRIGLEV is incremented by 1/(N*STEP) volts. (The value of STEP and the initial value of TRIGLEV are as last set in step 64 or 72 of FIG. 3.) The value of N is then doubled (step 94). If N is not greater than a constant NMAX (step 96), the computer sets each element of the data sequence last stored in acquisition memory 16 of FIG. 1 to the NULL value and then initiates digitization (step 98). The constant NMAX is suitably selected such that the product NMAX*STEP is equal to STEPMAX when 1/STEPMAX is the trigger level resolution. After waiting for a sufficient time, the computer checks the waveform data stored in the acquisition memory to determine if a NULL data value was replaced with another value (step 100). This happens when the trigger level is less than the maximum peak of the VOUT. In such event, the subroutine returns to step 92 where TRIGLEV is incremented by 1/(N*STEP) volts. Alternatively, when, in step 100, the computer determines that the trigger level was too low to permit triggering of data acquisition, TRIGLEV is decremented by 1/(N*STEP) volts (step 102). The subroutine continues to iterate through steps 94, 96, 98, 100 and 92 or 102 until the value of N exceeds NMAX. At this point, the subroutine sets the value of a variable MAXPEAK to the current value of TRIGLEV and returns. MAXPEAK is an estimate of the maximum peak level of VOUT, within the limits of resolution of the trigger level signal.

A subroutine capable of performing the binary search for the minimum peak (MINPEAK) level of VOUT performed at step 86 of FIG. 4 substantially the same as the subroutine illustrated in FIG. 5 except TRIGLEV is decremented (rather than incremented) in step 92, TRIGLEV is incremented (rather than decremented) in step 102, and MINPEAK (rather than MAXPEAK) is set equal TRIGLEV in step 104.

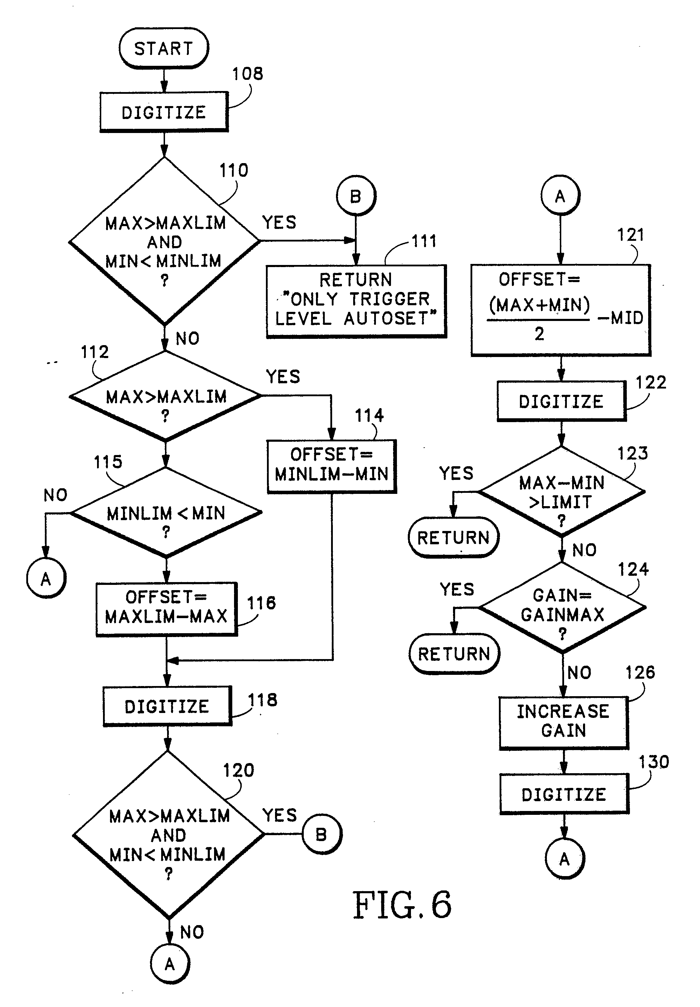

Referring again to FIG. 2, once the trigger level is set to midway between the maximum and minimum peaks of VOUT (step 46), a subroutine executed at step 48 iteratively adjusts offset and gain of the vertical amplifier 12 of FIG. 1. A suitable offset and gain adjustment subroutine is illustrated in FIG. 6.

Referring to FIG. 6, starting at step 108, the computer causes the system to digitize VOUT with the gain of the vertical amplifier still set at a minimum, the OFFSET signal still set at 0 volts, and the trigger level set midway between the last measured minimum and maximum peaks of VOUT. After a waveform data sequence has been acquired and stored in the acquisition memory 16 of FIG. 1, computer 22 reads out the data sequence to determine if the magnitude (MAX) of the largest data value in the sequence is larger than a predetermined maximum limit (MAXLIM) and the smallest (or most negative) element of the sequence (MIN) is less than (or more negative than) a predetermined minimum limit (MINLIM). MAXLIM and MINLIM are chosen so that when the minimum and maximum peaks of VOUT are outside of the +1 to -1 volt range of the digitizer, the outcome of step 110 is YES. This happens when the input signal magnitude is so large that the waveform display will be clipped, even when the amplifier gain is set to a minimum. In such case, the subroutine returns an "ONLY TRIGGER LEVEL AUTOSET" indication and ends (step 111).

Otherwise, if only the maximum data sequence value is out of range (step 112), the offset is set equal to MINLIM-MIN (step 114). Step 114 shifts VOUT so that the minimum peak of VOUT is at -1 volts. On the other hand, if only the minimum data sequence value is out of range (step 115), the offset is set to MAXLIM-MAX (step 116). Step 116 has the effect of shifting VOUT so that the maximum peak of VOUT is at +1 volts. After either step 114, or step 116, VOUT is again digitized (step 118). If either the maximum or minimum sequence values are still out of range (step 120), the subroutine returns an "ONLY TRIGGER LEVEL AUTOSET" indication (step 111).

When in either step 115 or step 120 the computer finds that the maximum and minimum elements of the waveform data sequence are within the prescribed limits, the computer tries to center the waveform vertically on the display screen by setting OFFSET to (MAX+MIN)/2-MID (step 121) and then re-acquires the waveform data sequence (step 122). Thereafter, the computer determines (step 123) whether the difference MAX-MIN is greater than a predetermined amplitude minimum limit (LIMIT). If so, the gain and offset of the vertical amplifier are considered to be appropriately adjusted, and the subroutine returns. If the difference MAX-MIN is not greater than LIMIT (step 123), and if the current gain setting is at a maximum (step 124), the minimum and maximum peaks of VOUT are adequately separated and the subroutine returns. When GAIN is not yet at a maximum (step 124), the computer increases the vertical amplifier gain to a next higher range (step 126), thereby increasing the separation between the minimum and maximum peaks of VOUT. The subroutine re-initiates digitization of VOUT (step 130) and thereafter reverts to step 121. The subroutine continues to iterate through steps 121, 122, 123, 124, 126 and 130 until at step 123 the range between the maximum and minimum data sequence values exceeds LIMIT or until at step 124 GAIN is at a maximum.

An oscilloscope screen is typically etched with a grid dividing the screen into "vertical grid divisions" enabling a user to gauge waveform magnitudes. The current vertical gain setting is usually not directly displayed but is indirectly displayed in the form of a vertical "range" denoted in "volts/division". The vertical range is proportional to the vertical amplifier gain. In a typical oscilloscope, gain is normally stepwise incremented or decremented only by factors of 2 and 2.5 so that each normal vertical range setting (in volts/division) is one of the set {..., 0.1, 0.2, 0.5, 1, 2, 5, ...}. In such case, the value of LIMIT used in step 122 for each given gain setting is suitably chosen to be 1/2.5 of the input range of the digitizer to ensure that the maximum and minimum of VOUT will remain within the vertical range of the digitizer (e.g., +1 volt to -1 volt) when vertical gain is thereafter increased by a factor of 2 or 2.5 in step 126. Thus, when the subroutine of FIG. 6 ends following step 122, vertical gain and offset are such that the minimum and maximum peaks of the waveform display controlled by the digitizer output will not be clipped and will be vertically centered about the middle of the oscilloscope screen and vertically separated by a substantial distance.

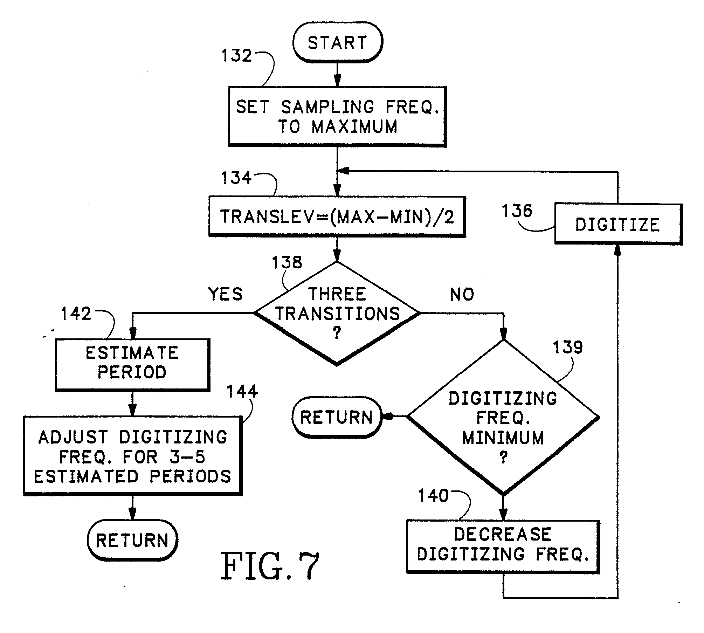

Referring again to FIG. 2, once the vertical gain and offset have been iteratively adjusted in step 48, the computer adjusts the digitizing frequency (step 50). FIG. 7 illustrates a suitable subroutine for carrying out step 50. The digitizing frequency of the system is initially set to a maximum (step 132) and a "transition level" variable (TRANSLEV) is set equal to one half the difference between maximum and minimum value elements of the last acquired waveform data sequence (step 134). The computer then checks the last acquired waveform data sequence to determine whether the sequence three times crossed (rose above or fell below) TRANSLEV (step 138) thereby suggesting that the sequence represents at least one full period of VOUT. If, in step 138, the computer determines that the last acquired waveform data sequence does not include two transitions, and if the digitizing frequency is already at a minimum (step 139), the subroutine ends. Otherwise, the computer decreases the digitizing frequency (step 140) and reinitiates digitization (step 136). It thereafter iteratively repeats steps 134, 138, 139, 140 and 136 until three transitions are detected in step 138 or until digitizing frequency has been decreased to a minimum.

When the computer detects three transitions, it estimates the period of VOUT (step 142) as being equal to the inverse of the digitizing frequency multiplied by the difference in data sequence position of data elements immediately preceding and immediately following the three transitions. The computer then adjusts the digitizing frequency so that digitizer output data sequences will represent three to five cycles of VOUT assuming that VOUT has the period estimated.

Referring again to FIG. 2, since the offset and gain adjustments performed in step 48 were based on a waveform data sequence acquired using minimum digitizing frequency, aliasing effects may cause the waveform data sequence to misrepresent the peak amplitudes and period of VOUT, particularly when the VOUT has a frequency greater than one half of the digitizing frequency. Thus, after the digitizing frequency is adjusted in step 50, usually to a much higher rate, the computer iteratively re-adjusts offset and gain (step 52) and re-adjusts digitizing frequency (step 54) suitably following procedures similar to those employed in steps 48 and 50. The re-adjustments performed in steps 52 and 54 substantially eliminate the effects of aliasing when the input signal frequency is within a normal range of the oscilloscope. The subroutine ends following step 54.

There has thus been described a digital oscilloscope including a computer for automatically adjusting trigger level, vertical gain, vertical offset, and digitizing frequency so that the oscilloscope provides a waveform display representing a few cycles of the amplifier output signal.

While a preferred embodiment of the present invention has been shown and described, it will be apparent to those skilled in the art that many changes and modifications may be made without departing from the invention in its broader aspects. The appended claims are therefore intended to cover all such changes and modifications as fall within the true spirit and scope of the invention.

**Claims**

1. In a digital oscilloscope comprising amplifier means for offsetting and amplifying an input signal with adjustable offset and gain to produce an output signal, digitizer means for digitizing said output signal after the output signal reaches an adjustable trigger level, thereby to produce waveform data sequences, each waveform data sequence comprising elements representing magnitudes of said amplifier means output signal during a time interval of duration determined by an adjustable digitizing frequency of said digitizer means, and a computer controlling said offset, gain and digitizing frequency and monitoring said output data sequences, a method for said computer for adjusting said trigger level, offset, gain and digitizing frequency, the method comprising the steps of:

iteratively adjusting said trigger level while monitoring waveform data sequences produced by said digitizer means thereby to measure minimum and maximum peaks of said amplifier means output signal,

adjusting the trigger level to a magnitude between the measured minimum and maximum peaks of said amplifier means output signal, and iteratively adjusting at least one of the gain and offset of said amplifier means while monitoring waveform data sequences produced by said digitizer means until a last produced waveform data sequence includes elements having maximum and minimum magnitudes within a predetermined range and differing by at least a minimum amount.

2. The method in accordance with claim 1 wherein the step of iteratively adjusting said trigger level while monitoring waveform data sequences produced by said digitizer means thereby to measure minimum and maximum peaks of said amplifier means output signal comprises the substeps of:

a. setting said trigger level to an initial value;

b. monitoring said waveform data sequences to determine if said amplifier means output signal reaches said trigger level;

c. altering said trigger level by an adjustable step amount when said amplifier means output signal is determined in step b to have reached said trigger level;

d. altering said trigger level by an inverse of said adjustable step amount when said amplifier means output signal is determined in step b not to have reached said trigger level;

e. decreasing said adjustable step amount; and

f. repeating steps b through e until said adjustable step amount reaches a predetermined lower limit.

3. The method in accordance with claim 1 further comprising the steps of:

estimating a period of said amplifier means output signal from said last produced waveform data sequence, and

adjusting said digitizing frequency so that a next produced waveform data sequence represents a time interval spanning at least one estimated period.

4. The method in accordance with claim 3 further comprising the step of iteratively re-adjusting at least one of gain and offset of said amplifier means while monitoring waveform data sequences produced by said digitizer means until said digitizer means produces another waveform data sequence having elements with maximum and minimum magnitudes within said predetermined range and differing by at least said minimum amount.

5. The method in accordance with claim 4 further comprising the steps of:

re-estimating said period of said amplifier means output signal from said another waveform data sequence, and

re-adjusting said digitizing frequency so that a next produced waveform data sequence represents a time interval spanning at least one re-estimated period.

6. In a digital oscilloscope comprising amplifier means for offsetting and amplifying an input signal with adjustable offset and gain to produce an output signal, and digitizer means for digitizing said output signal after the output signal reaches an adjustable trigger level, thereby to produce waveform data sequences, each waveform data sequence comprising elements representing magnitudes of said amplifier means output signal during a time interval of duration determined by an adjustable digitizing frequency of said digitizer means, and a computer for adjusting said offset, gain and digitizing frequency and monitoring said output data sequences, a method for said computer for adjusting said trigger level, offset, gain and digitizing frequency, the method comprising the steps of:

adjusting said gain and said digitizing frequency to minimum initial values,

iteratively adjusting said trigger level while monitoring said waveform data sequences thereby to measure minimum and maximum peaks of said amplifier means output signal; and

setting the trigger level between the measured minimum and maximum peaks.

7. The method in accordance with claim 6 wherein the step of iteratively adjusting said trigger level while monitoring waveform data sequences produced by said digitizer means thereby to measure minimum and maximum peaks of said amplifier means output signal comprises the substeps of:

a. setting said trigger level to an initial value;

b. monitoring said waveform data sequences to determine if said amplifier means output signal reaches said trigger level;

c. altering said trigger level by an adjustable step amount when said amplifier means output signal is determined in step b to have reached said trigger level;

d. altering said trigger level by an inverse of said adjustable step amount when said amplifier means output signal is determined in step b not to have reached said trigger level;

e. decreasing said adjustable step amount; and

f. repeating steps b through e until said adjustable step amount reaches a predetermined lower limit.

8. The method in accordance with claim 6 further comprising the step of iteratively adjusting at least one of said gain and offset while monitoring waveform data sequences until a last produced waveform data sequence of said digitizer has minimum and maximum peaks within a predetermined range and differing by at least a minimum amount.

9. The method in accordance with claim 8 further comprising the steps of:

estimating a period of said amplifier means output signal from said last produced waveform data sequence, and

adjusting said digitizing frequency so that a next produced waveform data sequence represents a time interval spanning at least one estimated period.

10. The method in accordance with claim 9 further comprising the steps of:

re-estimating said period of said amplifier means output signal from said another waveform data sequence, and

re-adjusting said digitizing frequency so that a next produced waveform data sequence represents a time interval spanning at least one re-estimated period.

11. A digital oscilloscope comprising:

amplifier means for offsetting and amplifying an input signal with adjustable offset and gain to produce an output signal;

digitizer means for repetitively digitizing said output signal after the output signal reaches an adjustable trigger level, thereby to produce waveform data sequences, each waveform data sequence representing magnitudes of said amplifier means output signal during a time interval of duration determined by an adjustable digitizing frequency;

a screen for displaying a waveform;

display control means receiving said waveform data sequence for generating a waveform display on said screen, said waveform display representing said waveform data sequence; and

a computer means for iteratively adjusting gain and offset while monitoring said waveform data sequence until a last produced waveform data sequence of said digitizer is such that said display control means would produce a waveform display having minimum and maximum peaks appearing on said screen and vertically separated by a substantial distance, then estimating a period of said amplifier means output signal from said last produced waveform data sequence, and then adjusting said digitizing frequency so that a next produced waveform data sequence represents a time interval spanning at least one estimated period.

FIG.1

EP 0 349 328 A2

FIG.2

EP 0 349 328 A2

FIG.3

FIG.4

FIG.5

FIG.6

FIG.7